# EUROPEAN PATENT SPECIFICATION

(11) **EP 2 595 275 B1**
(45) Date of publication and mention of the grant of the patent: **11.05.2016**
(21) Application number: 11806778.4
(22) Date of filing: 12.07.2011
(51) Int. Cl.: H02J 7/00, G01R 31/02, G01R 31/36

(54) **ASSEMBLED-BATTERY VOLTAGE EQUALIZATION APPARATUS**
VORRICHTUNG ZUM SPANNUNGSAUSGLEICH EINER ZUSAMMENGESETZTEN BATTERIE
APPAREIL D'ÉGALISATION DE TENSION POUR BATTERIE ASSEMBLÉE

(30) Priority: 14.07.2010 JP 2010159441
(43) Date of publication of application: 22.05.2013
(73) Proprietor: Yazaki Corporation, Minato-ku Tokyo 108-0073 (JP)
(72) Inventor: IZAWA, Takaaki, Susono-shi, Shizuoka 410-1107 (JP)
(74) Representative: Hoffmann Eitle
(86) International application number: PCT/JP2011/065888
(87) International publication number: WO 2012/008448

(56) References cited:
- JP-A- 2005 318 750
- JP-A- 2008 175 804
- JP-A- 2009 159 769
- US-A- 5 965 996
- US-A1- 2005 242 667
- US-A1- 2009 085 516

## Description

### Technical Field

The present invention relates to a voltage equalizer for a battery pack which connects one or more battery blocks in series and outputs a given voltage, the voltage equalizer equalizing an output voltage of each of the battery blocks.

### Background Art

A secondary battery installed in a hybrid vehicle or an electric vehicle, for example, includes a series circuit in which a plurality of unit cells outputting given voltages are connected in series, and generates a high-voltage electric power such as 200 V at both ends of the series circuit. By using the electric power of the secondary battery, a driving motor is driven. In such a battery pack in which a plurality of unit cells are connected in series, an equalization switch is provided to cause short circuit through a discharge resistor between a positive electrode and a negative electrode of each of the unit cells or each battery block including a plurality of unit cells, for the purpose of equalizing an output voltage of each of the unit cells. For the unit cell or the battery block outputting a higher voltage, the equalization switch is switched on (circuit is closed) to consume electric power so that the output voltage is controlled to coincide with output voltages of other unit cells or battery blocks.

In the voltage equalizing circuit stated above, when the circuit has a failure, a problem happens that the output voltage of each of the unit cells or the battery blocks is not able to be equalized. Therefore, as described in PTL 1, an equalizer has been proposed which has a function to diagnose whether or not an equalizing circuit is operating in conformity.

Fig. 1 is an explanatory diagram schematically illustrating an equalizer described in PTL 1, in which a positive electrode of a unit cell 51 to be equalized is connected to a terminal T51 of a measuring device 52 through a resistor R51 and a switch SW51, a negative electrode thereof is connected to a terminal T52 of the measuring device 52 through a resistor R52 and a switch SW52. Between the two terminals T51 and T52 of the measuring device 52, a series circuit of a switch SW53 and a resistor R53 is provided. When equalizing voltages, the switch SW53 is switched on in a state where both of the respective switches SW51 and SW52 are switched on, so discharge current flows in the discharge resistor 53 and electric power of the unit cell 51 is consumed, thus reducing a voltage of the unit cell 51.

Further, when diagnosing the switch SW53, while both of the respective switches SW51 and SW52 are switched on, the measuring device 52 measures a voltage between the terminals in a case where the switch SW53 is switched off, and a voltage between the terminals in a case where the switch SW53 is switched on, and, based on a result of the measurement, it is determined whether or not the equalization switch SW53 operates in conformity. In other words, the measuring device 52 detects a voltage across both terminals of the unit cell 51 when the switch SW53 is off, and the measuring device 52 detects a voltage corresponding to a voltage dividing ratio of the resistors R51 to R53 when the switch SW53 is on, which makes it possible to determine whether or not the equalization switch SW53 is operating in conformity, based on the detected voltages.

### Citation List

### Patent Literature

PTL 1: JP 2009-159769 A
US 2005/242667 A1 discusses a battery control system that comprises a plurality of unit battery cells each consisting of multiple battery cells. Each battery cell is connected to a resistor and a balancing switch. A comparison means compares a drive signal and voltages sensed by a SW condition sensing means.

### Summary of Invention

However, in the equalizer of PTL 1, since it is necessary to detect voltages in the two states where the equalization switch SW53 is on and off, there is a problem that the number of steps required for failure diagnosis is too many. Although it is possible to diagnose whether or not the equalization switch SW53 operates in conformity, there is a defect that, when there is a failure in a driving system (not illustrated) which operates the equalization switch SW53, it is not possible to detect the failure. Therefore, a problem may happen that nonconformity is falsely detected even when the equalization switch SW53 is operating in conformity.

The present invention has been made for solving these conventional problems, and an object of the present invention is to provide a voltage equalizer for a battery pack, the voltage equalizer being able to ensure swift detection of nonconformity in an equalization circuit which equalizes a voltage of each battery block that constructs a battery pack.

In order to achieve the above object, a voltage equalizer according to a first aspect of the present invention is provided with a battery pack including a series circuit in which one or more battery blocks each made of one or more unit cells are connected in series, the battery pack for generating a desired voltage at both ends of the series circuit, the voltage equalizer for equalizing output voltages of the battery blocks. The voltage equalizer includes discharge resistors, equalization switches, an equalization controlling unit, and an equalization diagnostic unit. Each of the discharge resistors is provided at least one of a positive electrode and a negative electrode of each of the battery blocks. Each of the equalization switches is provided between the positive electrode and the negative electrode of each of the battery blocks and switches between connection and disconnection of the positive electrode and the negative electrode of each of the battery blocks through corresponding discharge resistor. The equalization controlling unit generates an equalization control signal made of a bit string of a first status signal or a second status signal that determines connection or disconnection of each of the equation switches when an equalization start command is given, and outputs the equalization control signal to the corresponding equalization switch so as to control connection and disconnection of the equalization switches. The equalization diagnostic unit obtains an equalization detection signal of each of the battery blocks, the equalization detection signal being made of a bit string of the first status signal or the second status signal based on a voltage generated at a connection point of the equalization switch and the discharge resistor corresponding to each of the battery blocks, also obtains the equalization control signal, and diagnoses an operation status of each of the equalization switches based on the equalization detection signal and the equalization control signal. The equalization diagnostic unit compares the equalization detection signal corresponding to the equalization switch to the equalization control signal and determining whether or not equalization processing is executed in conformity for each of the battery blocks based on a result of the comparison.

The voltage equalizer according to the first aspect of the prevent invention further includes a latch circuit which outputs one of the first status signal and the second status signal when the equalization start command is given, and outputs the other one of the first status signal and the second status signal when the equalization end command is given. In this case, the equalization diagnostic unit determines whether or not the equalization processing for each of the battery blocks is executed in conformity in view of a latch signal that is an output signal from the latch circuit, in addition to the comparison between the equalization detection signal corresponding to the equalization switch and the equalization control signal.

In the voltage equalizer according to the first aspect of the present invention, it is preferable that, with regard to corresponding battery block, the equalization controlling unit outputs the equalization control signal that is the first status signal when equalization is executed, and outputs the equalization control signal that is the second status signal when equalization is not executed. In this case, the equalization detection signal is the first status signal when the equalization switch corresponding to the battery block is connected, and is the second status signal when the equalization switch is disconnected. Further, the equalization diagnostic unit determines for the equalization switch corresponding to the battery block that an operation of the equalization switch is conformity when the equalization detection signal and the equalization control signal coincide with each other, and that the operation of the equalization switch is nonconformity when the equalization detection signal and the equalization control signal do not coincide with each other.

With the voltage equalizer according to the first aspect of the present invention, it is preferable that the latch signal becomes the first status signal when the equalization start command is given, and becomes the second status signal when the equalization end command is given. In this case, with regard to the corresponding battery block, the equalization diagnostic unit determines that the operation of the equalization switch is conformity when the latch signal is the first status signal and both of the equalization detection signal and the equalization control signal are the first status signals, and determines that the operation of the equalization switch is nonconformity when the latch signal is the second status signal, and at least one of the equalization detection signal and the equalization control signal is the first status signal.

In the voltage equalizer according to the first aspect of the present invention, since it is possible to diagnose whether or not the equalization processing is executed in conformity in each of the battery blocks, based on the equalization control signal and the equalization detection signal, it is not necessary to have many steps, and nonconformity of the equalization processing is able to be detected highly accurately.

### Brief Description of Drawings

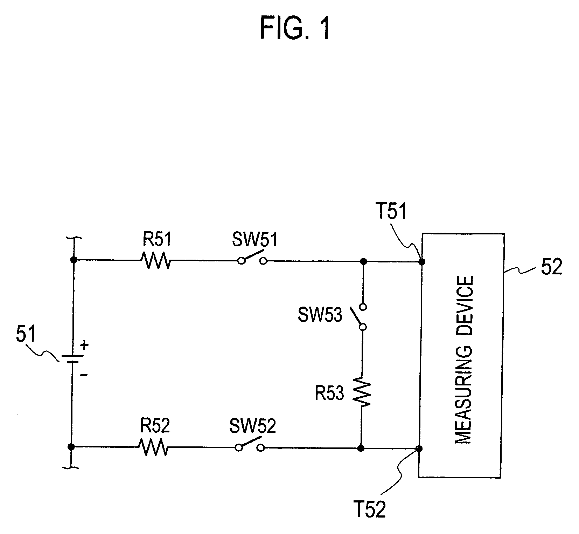

[Fig. 1] Fig. 1 is a circuit diagram of a conventional equalizer.
[Fig. 2] Fig. 2 is a circuit diagram illustrating a configuration of a voltage equalizer according to each of first and second embodiments.
[Fig. 3] Fig. 3 is an explanatory diagram illustrating an output signal of a latch circuit provided in the voltage equalizer according to each of the first and second embodiments.
[Fig. 4] Fig. 4 is a flowchart illustrating a procedure of processing by the voltage equalizer according to the first embodiment.
[Fig. 5] Fig. 5 is a flowchart illustrating a procedure of processing by the voltage equalizer according to the second embodiment.
[Fig. 6] Fig. 6 is a circuit diagram illustrating a configuration of a modified example of the voltage equalizer according to each of the first and second embodiments.

### Description of Embodiments

Next, embodiments of the present invention will be explained based on the drawings.

### (Description of First Embodiment)

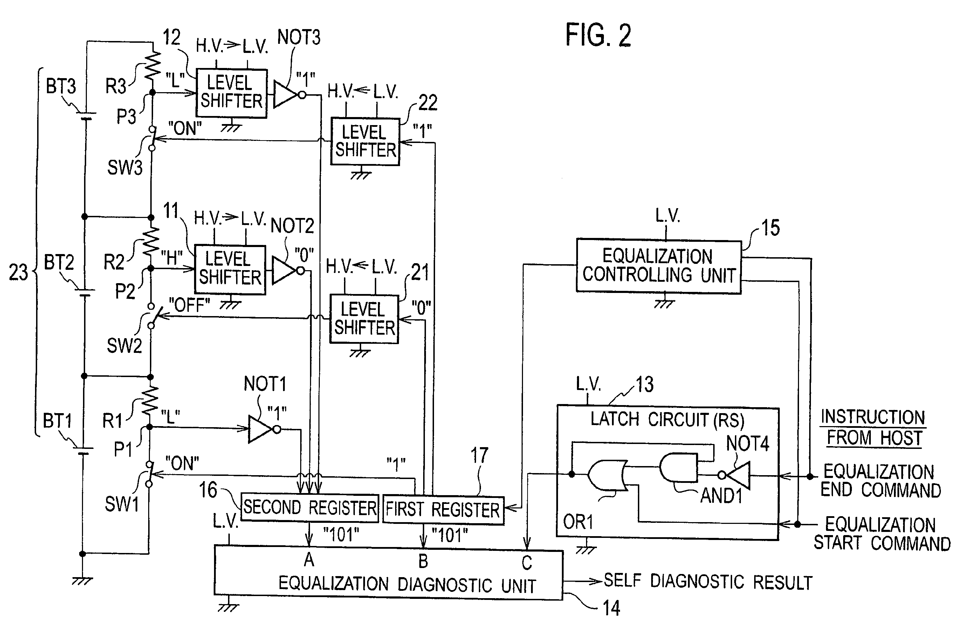

Fig. 2 is a block diagram illustrating configurations of a voltage equalizer for a battery pack according to the first embodiment and of a battery pack 23 connected to the voltage equalizer. As illustrated in Fig. 2, the battery pack 23 is used as, for example, a secondary battery provided in an electric vehicle, and includes three unit cells BT 1 to BT3 (for example, lithium-ion cells) that are connected to each other in series. In first and second embodiments, three unit cells BT1 to BT3 are provided for easier understanding of the descriptions, but the number of the unit cells may be one, two, four, or more.

The voltage equalizer illustrated in Fig. 2 includes a latch circuit 13, an equalization controlling unit 15, and an equalizing diagnostic unit 14. Based on an equalization start command or an equalization end command provided from a host system, the latch circuit 13 outputs a latch signal that indicates "1" (first status signal) or "0" (second status signal) indicating whether or not equalization control is to be executed. The equalization controlling unit 15 outputs an equalization control signal formed of a bit string of "1" or "0", based on the equalization start command and the equalization end command. Based on the latch signal outputted from the latch circuit 13, the equalization control signal outputted from the equalization controlling unit 15, and a later-described equalization detection signal, the equalization diagnostic unit 14 diagnoses whether or not the voltage equalization processing is executed in conformity.

The latch circuit 13 includes a NOT gate NOT4, an AND gate AND1, and an OR gate OR1, and latches an output signal to "1" (H-level) when the equalization start command is inputted, and latches an output signal to "0" (L-level) when the equalization end command is inputted. The latch signal formed of "1" or "0" and outputted from the latch circuit 13 is supplied to a terminal "C" of the equalization diagnostic unit 14.

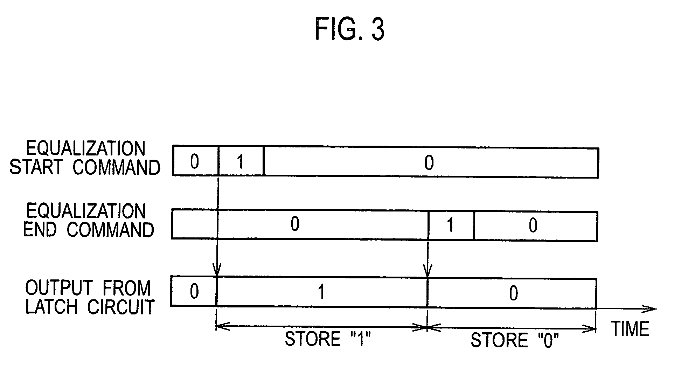

As illustrated in Fig. 3, the output signal from the latch circuit 13 operates as follows. First, once the equalization start command is switched from "0" to "1", the latch signal is changed from "0" to "1". Thereafter, the latch signal is retained at "1" even if the equalization start command is changed to "0". Then, once the equalization end command is switched from "0" to "1", the latch signal is changed from "1" to "0". Thereafter, the latch signal is retained at "0" even if the equalization end command is changed to "0".

The equalization controlling unit 15 illustrated in Fig. 2 outputs the equalization control signal that is a bit string corresponding to the number of unit cells BT1 to BT3. To be specific, the equalization controlling unit 15 outputs the equalization control signal that is a bit string in which a bit corresponding to a unit cell that is determined that the output voltage thereof is too high (description of a method for measuring a voltage is omitted) is "1" (a first status signal), and a bit corresponding to a unit cell that is determined that the output voltage thereof is conformity is "0" (a second status signal). For example, in a case where it is determined from a result of voltage measurement that an output voltage of the unit cell BT2 is conformity and output voltages of the unit cells BT1 and BT3 are too high, the equalization controlling unit 15 outputs an equalization control signal that is a bit string of "1, 0, 1" in the order of BT1, BT2 and BT3.

This equalization control signal is stored in a first register 17 temporarily, and then outputted to equalization switches SW1 to SW3 (described later) provided in the unit cells BT1 to BT3, respectively. Specifically, a bit signal of "1" is outputted to the equalization switches SW1 and SW3 so that the equalization switches SW1 and SW3 are instructed to be switched on, and a bit signal of "0" is outputted to the equalization switch SW2 so that the equalization switch SW2 is instructed to be switched off. The equalization control signal "1, 0, 1" stored in the first register 17 is also supplied to a terminal "B" of the equalization diagnostic unit 14.

Between a positive electrode and a negative electrode (ground) of the unit cell BT1, a series circuit of a discharge resistor R1 and the equalization switch SW1 is provided. A connection point P1 of the discharge resistor R1 and the equalization switch SW1 is connected to a second register 16 through a NOT gate NOT1. When a voltage at the connection point P1 is in the H-level, an output signal from the NOT gate NOT1 is in the L-level (which is "0"). When the voltage at the connection point P1 is in the L-level, an output signal from the NOT gate NOT1 is in the H-level (which is "1"). The output signal from the NOT gate NOT1 is supplied to the second register 16.

Between a positive electrode and a negative electrode (the positive electrode of BT1) of the unit cell BT2, a series circuit of a discharge resistor R2 and the equalization switch SW2 is provided. A connection point P2 of the discharge resistor R2 and the equalization switch SW2 is connected to the second register 16 through a level shifter 11 and a NOT gate NOT2. The level shifter 11 is a circuit which converts a voltage generated at the connection point P2 into a voltage relative to the negative electrode of the unit cell BT2. When the voltage at the connection point P2 is in the H-level, an output signal from the NOT gate NOT2 is "0". When the voltage at the connection point P2 is in the L-level, the output signal from the NOT gate NOT2 is "1".

Between a positive electrode and a negative electrode (the positive electrode of BT2) of the unit cell BT3, a series circuit of a discharge resistor R3 and the equalization switch SW3 is provided. A connection point P3 of the discharge resistor R3 and the equalization switch SW3 is connected to the second register 16 through a level shifter 12 and a NOT gate NOT3. The level shifter 12 is a circuit which converts a voltage generated at the connection point P3 into a voltage relative to the negative electrode of the unit cell BT3. When the voltage at the connection point P3 is in the H-level, an output signal from the NOT gate NOT3 is "0". When the voltage at the connection point P3 is in the L-level, the output signal from the NOT gate NOT3 is "1".

The second register 16 temporarily stores the equalization detection signal made of a bit string having three of "0" or "1" ("1, 0, 1" in this example) outputted from the respective NOT gates NOT1 to NOT3, and outputs the equalization detection signal to the equalization diagnostic unit 14. The equalization detection signal is supplied to a terminal A of the equalization diagnostic unit 14.

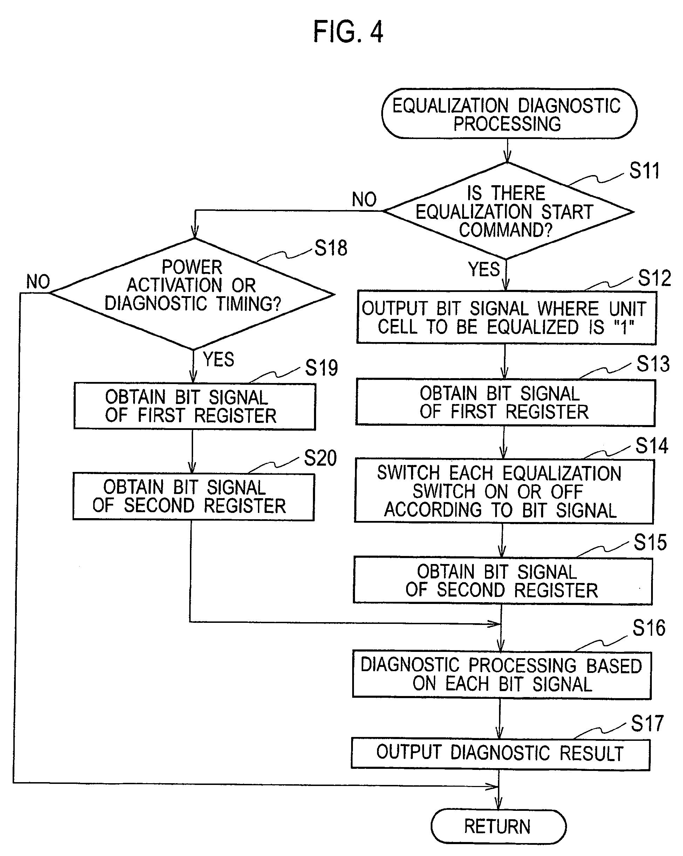

Next, an operation of the voltage equalizer according to the first embodiment will be explained with reference to a flowchart illustrated in Fig. 4. First, it is determined whether or not the equalization start command is inputted to the latch circuit 13 (step S11). In a case where the equalization start command is not inputted (NO in step S11), the processing moves to step S18. On the other hand, in a case where the equalization start command is inputted (YES in step S11), the equalization controlling unit 15 generates the equalization control signal that is a bit string in which a bit corresponding to the unit cell for equalization is "1", and outputs the equalization control signal to the first register 17 (step S12). For example, when the unit cells BT1 and BT3 are to be equalized, the equalization controlling unit 15 outputs the equalization control signal which is a bit string of "1, 0, 1".

The equalization control signal is supplied to the terminal "B" of the equalization diagnostic unit 14 (step S13), and is also supplied to the respective equalization switches SW1 to SW3. Then, the respective equalization switches SW1 to SW3 are switched on or off in accordance with the equalization control signal (step S14). In this example, the equalization switches SW1 and SW3 are switched on, and the equalization switch SW2 is switched off.

As a result, since the positive electrodes and the negative electrodes of the respective unit cells BT1 and BT3 are electrically connected to each other through the discharge resistors R1 and R3, respectively, discharge current flows in the discharge resistors R1 and R3 and electric power is consumed, thus bringing voltages of the respective unit cells BT1 and BT3 down to a conformity voltage value. In short, equalization processing for the respective unit cells BT1 to BT3 is executed.

Next, bit signals of "1" or "0" depending on values of voltages generated at the connection points P1 to P3 of the respective equalization switches SW1 to SW3 and the respective discharge resistors R1 to R3 are supplied to the second register 16. These signals are outputted by the second register 16 to the equalization diagnostic unit 14 as the equalization detection signal that is a bit string corresponding to the respective equalization switches SW1 to SW3. As a result, the equalization detection signal is supplied to the terminal "A" of the equalization diagnostic unit 14 (step S 15).

In the first embodiment, since the equalization switch SW1 is switched on, the voltage at the connection point P1 is "0" that indicates a ground voltage, and "1" which is obtained by inverting "0" is supplied to the second register 16. Further, since the equalization switch SW2 is switched off, the voltage at the connection point P2 is "1" that indicates the same voltage as the positive electrode of the unit cell BT2, and "0" which is obtained by inverting "1" is supplied to the second register 16. Yet further, since the equalization switch SW3 is switched on, the voltage at the connection point P3 is "0" that indicates the same voltage as the negative electrode of the unit cell BT3, and "1" which is obtained by inverting "0" is supplied to the second register 16.

Therefore, the bit string of the equalization detection signal outputted from the second register 16 is "1, 0, 1", and this bit string is supplied to the terminal "A" of the equalization diagnostic unit 14.

Then, based on the equalization detection signal supplied to the terminal "A" and the equalization control signal supplied to the terminal "B", the equalization diagnostic unit 14 diagnoses whether or not the equalization processing is executed in conformity (step S 16).

Meanwhile, in a case where it is determined as NO in step S11, it is determined whether or not it is power activation timing or diagnostic timing (step S 18). In other words, the equalization diagnostic unit 14 determines whether or not the equalization is executed in conformity at the power activation timing or at the diagnostic timing set at given intervals, even when the equalization is not executed.

In a case where it is neither the power activation timing nor the diagnostic timing (NO in step S18), the processing is ended. When it is the power activation timing or the diagnostic timing (YES in step S18), the equalization diagnostic unit 14 obtains the bit signals stored in the first register 17 (step S19). The equalization diagnostic unit 14 also obtains the bit signals stored in the second register 16 (step S20).

Thereafter, through the processing of step S16, the equalization diagnostic unit 14 diagnoses whether or not the equalization processing is executed in conformity, based on the equalization detection signal supplied to the terminal "A" and the equalization control signal supplied to the terminal "B".

Diagnostic processing executed by the equalization diagnostic unit 14 will be explained below with reference to a truth table illustrated in Table 1.

**[Table 1]**

| input A | input B | output |
|---|---|---|
| equalization detection signal | equalization control signal | |
| 0 | 0 | conformity |
| 0 | 1 | nonconformity |
| 1 | 0 | nonconformity |
| 1 | 1 | conformity |

Table 1 is a truth table which indicates a relation between statuses of the equalization detection signal inputted to the terminal "A" (referred to as "input A") and the equalization control signal inputted to the terminal "B" (referred to as "input B"), and a diagnostic result. As indicated in Table 1, when both of the input A and input B are "0" or "1" (in other words, both of the bit signals coincide with each other), it is determined that the operation of equalization is conformity. Meanwhile, when one of the input A and the input B is "0" and the other is "1" (in other words, the bit signals do not coincide with each other), it is determined that the operation of the equalization is nonconformity.

Namely, it is determined that the operation of the equalization is nonconformity when the equalization switch is not switched on even though the equalization control signal is outputted, or, when the equalization switch is switched on even though the equalization control signal is not outputted.

Then, the equalization controlling unit 14 outputs an output signal according to the diagnostic result to an alarm device (not illustrated) or the like provided in a subsequent stage (step S 17), thus notifying an operator that there is nonconformity in the operation of the equalization.

In the voltage equalizer for a battery pack according to the first embodiment of the present invention, it is diagnosed whether or not the operation of the equalization is conformity based on the equalization control signal outputted from the equalization controlling unit 15 with regard to the respective unit cells BT1 to BT3, and the equalizing detection signal outputted from the respective unit cells BT1 to BT3. That is, it is determined whether or not the operation of the equalization is conformity by detecting whether or not bit signals of the input A and the input B inputted to the equalization diagnostic unit 14 coincide with each other.

Therefore, when nonconformity is discovered such as that the equalization is not performed even though an instruction of the operation of the equalization is received, or that the equalization is performed even though the instruction of the operation of the equalization is not received, the nonconformity is able to be immediately recognized and notified to an operator.

As a result, without needing complicated operations like those in conventional technique such as comparison of differences of voltage values when the equalization switch is switched on and off, it is possible to determine whether or not the circuits from the equalization controlling unit 15 through the respective equalization switches SW1 to SW3 operate in conformity.

Further, in the first embodiment, the equalizing switch is provided in each of the unit cells, and, when output voltage of one or more of the unit cells are too high, corresponding equalization switches are switched on so that the output voltage from corresponding unit cells are equalized. Thus, the output voltages from the respective unit cells that construct the battery pack 23 are kept constant.

### (Description of Second Embodiment)

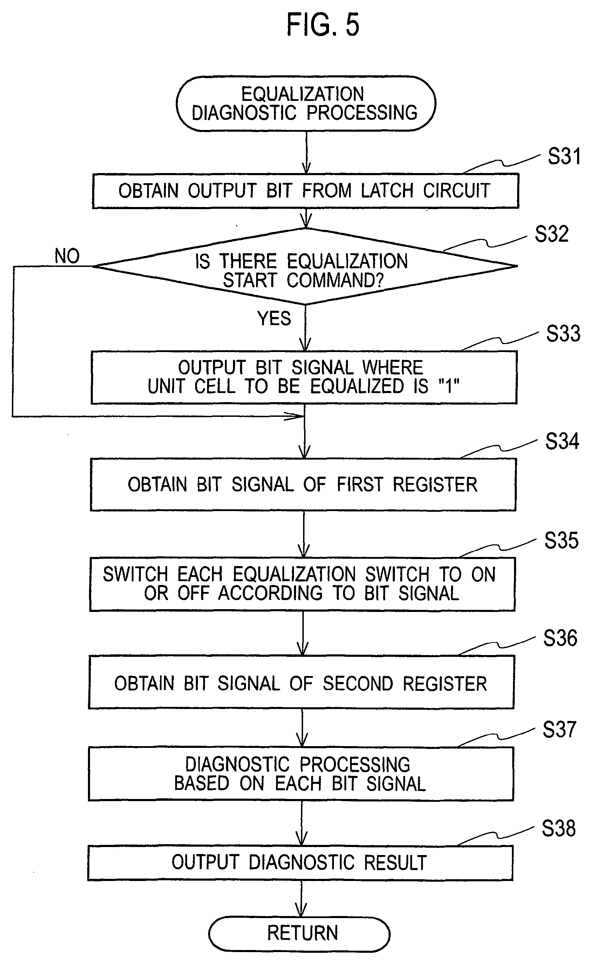

Next, the second embodiment will be explained. A voltage equalizer for a battery pack according to the second embodiment has the same configuration as the circuit illustrated in Fig. 2 except that a procedure of diagnostic processing by an equalization diagnostic unit 14 is different. That is, in the first embodiment, the example was set forth where it is diagnosed whether or not the operation of the equalization is conformity based on the equalization detection signal (input A) and the equalization control signal (input B) supplied to the equalization diagnostic unit 14. On the contrary, in the second embodiment, it is diagnosed whether or not equalization processing is executed in conformity based on a latch signal (referred to as "input C") supplied to a terminal "C", in addition to input A and input B. A processing operation of the voltage equalizer according to the second embodiment will be described below with reference to a truth table illustrated in Table 2 and a flowchart illustrated in Fig. 5.

**[Table 2]**

| input A | input B | input C | output |
|---|---|---|---|
| equalization detection signal | equalization control signal | latch signal | |
| 0 | 0 | 0 | conformity: waiting for equalization command |
| 0 | 0 | 1 | determined with limited bits |
| 0 | 1 | 0 | nonconformity: combined failure |
| 0 | 1 | 1 | nonconformity: open-circuit failure of equalization SW |
| 1 | 0 | 0 | nonconformity: short-circuit failure of equalization SW |
| 1 | 0 | 1 | nonconformity: combined failure |
| 1 | 1 | 0 | nonconformity: combined failure |
| 1 | 1 | 1 | conformity: equalization in progress |

Table 2 is a truth table which indicates a relation between statuses of input A, input B, and input C supplied to an equalization diagnostic unit 14, and a diagnostic result. In the truth table of Table 2, it is determined whether or not there is a failure happening in the equalizer based on the respective statuses of the inputs A to C. In other words, when input C is "0", it is determined that an operation of equalization is conformity in a case of "0, 0, 0" for the inputs A, B, and C in this order, it is determined that there is a combined failure in a case of "0, 1, 0", it is determined that there is a short-circuit failure of the equalization switch in a case of"1, 0, 0", and it is determined that there is a combined failure in a case of "1, 1,0".

Also, when input C is "1", it is determined that the operation of the equalization is conformity in a case where a bit signal of the input A and a bit signal of the input B coincide with each other, and it is determined that there is a failure in the equalizer in a case where the bit signals do not coincide with each other. In this determination, it is determined that there is an open-circuit failure of the equalization switch in a case of "0, 1, 1" for the inputs A, B, and C in this order, and it is determined that there is a combined failure in a case of "1, 0, 1", and it is determined that the operation of the equalization is conformity in a case of"1, 1, 1". Nevertheless, in a case of "0, 0, 1", the determination is made for limited bits. Namely, even when the input C that is an output signal from the latch circuit 13 is "1", the operation of the equalization is conformity when both the input A and the input B are "0" with respect to the unit cell BT2 which is not a subject of the equalization, so the determination of conformity or nonconformity is made depending on bits.

Next, an operation of the voltage equalizer according to the second embodiment will be described with reference to the flowchart illustrated in Fig. 5.

First, the equalization diagnostic unit 14 obtains the latch signal (output bit) outputted from the latch circuit 13 (step S31). In other words, when an equalization start command is given by a host device, a bit signal of "1" is outputted from the latch circuit 13 and supplied to an input "C" of the equalization diagnostic unit 14. Also, when an equalization end command is given by the host device, a bit signal of "0" is outputted from the latch signal 13 and is supplied to the input C of the equalization diagnostic unit 14.

Next, the equalization diagnostic unit 14 determines whether or not the output bit from the latch circuit 13 is "1" (step S32), and, the processing moves to step S33 when the output bit is "1", and the processing moves to step S34 when the output bit is "0".

In step S33, an equalization controlling unit 15 generates and outputs the equalization control signal that is a bit signal in which a bit corresponding to a unit cell to be equalized is "1 ". For example, in a case where unit cells BT1 and BT3 are equalized and a unit cell BT2 is not equalized, the equalization control signal is "1, 0, 1".

In step S34, the equalization diagnostic unit 14 obtains the bit signal (equalization control signal) outputted from the equalization controlling unit 15. In other words, the equalization control signal outputted from the equalization controlling unit 15 is supplied to a terminal "B" of the equalization diagnostic unit 14, and the equalization diagnostic unit 14 obtains the equalization control signal. When the output bit from the latch circuit 13 is "0", since the equalization controlling unit 15 outputs "0, 0, 0", the equalization control signal of "0, 0, 0" is supplied to the terminal "B" of the equalization diagnostic unit 14.

In addition, the equalization control signal is supplied to the respective equalization switches SW1 to SW3. Then, the respective equalization switches SW1 to SW3 are switched on or off in accordance with the equalization control signal (step S35). In this example, the equalization switches SW1 and SW3 are switched on, and the equalization switch SW2 is switched off.

As a result, since the positive electrode and the negative electrode of each of the unit cells BT1 and BT3 are electrically connected to each other through discharge resistors R1 and R3, respectively, discharge current flows in each of the discharge resistors R1 and R3, and electric power is consumed by each of the discharge resistors R1 and R3, thereby bringing voltage of each of the unit cells BT1 and BT3 to down to a conformity voltage value. In short, equalization processing for the respective unit cells BT1 to BT3 is executed.

Next, bit signals of "1" or "0" depending on values of voltages generated at connection points P1 to P3 of the respective equalization switches SW1 to SW3 and the respective discharge resistors R1 to R3 are supplied to a second register 16. These signals are outputted by the second register 16 to the equalization diagnostic unit 14 as the equalization detection signal that is a bit string corresponding to the respective equalization switches SW1 to SW3. As a result, the equalization detection signal is supplied to a terminal "A" of the equalization diagnostic unit 14 (step S36).

Then, similarly to the first embodiment described earlier, it is diagnosed whether or not an operation of the equalization is conformity based on the truth table illustrated in Table 2 and the respective bit signals obtained by the respective terminals "A", "B", and "C" of the equalization diagnostic unit 14 (step S37).

Thereafter, the result of the diagnosis is outputted to the alarm device (not illustrated) provided in the subsequent stage (step S38) thereby notifying an operator that there is nonconformity in the operation of the equalization.

In the voltage equalizer according to the second embodiment of the present invention, it is diagnosed whether or not the operation of the equalization is executed in conformity based on the equalization control signal outputted from the equalization controlling unit 15 with regard to the respective unit cells BT1 to BT3, the equalizing detection signal outputted from the respective unit cells BT1 to BT3, and the latch signal outputted from the latch circuit 13. That is, when the latch signal is "0" or "1", it is determined whether or not the operation of the equalization is conformity by detecting agreement or disagreement between input A and input B inputted to the equalizing diagnostic unit 14.

Therefore, similarly to the first embodiment, when there is nonconformity such as that the equalization is not performed even though an instruction of the operation of the equalization is received, or that the equalization is performed even though the instruction of the operation of the equalization is not received, the nonconformity is able to be immediately recognized and notified to an operator.

Consequently, it is possible to diagnose whether or not the circuits from the equalization controlling unit 15 through the respective equalization switches SW1 to SW3 operate in conformity without needing complicated operations like those in conventional technique such as comparison of voltage values when the equalization switch is switched on and off.

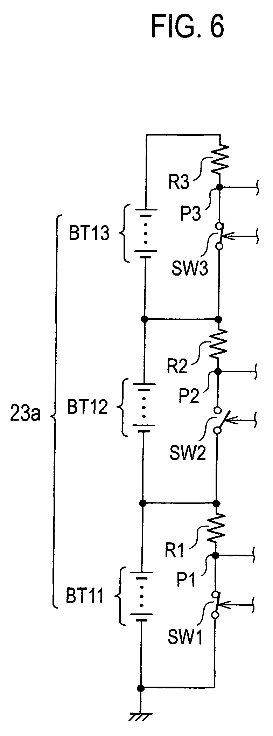

In the first and second embodiments set forth above, the example was explained in which the equalization is performed for the three unit cells BT1 to BT3 provided in the battery pack 23, but a voltage equalizer may be configured so that equalization of output voltages is performed for every plurality of unit cells that are connected to each other in series. Namely, as illustrated in Fig. 6, a battery pack 23a is configured by serially connecting battery blocks BT11, BT12, and BT13, each being made of a plurality of battery packs, and a voltage of each of the battery blocks BT11 to BT13 is measured. Then, a configuration may be such that, when the voltage is high, equalization switches SW1 to SW3 are switched on so that the output voltage of each of the battery blocks BT11 to BT13 is equalized. In this case, the number of the unit cells provided in each of the battery blocks BT11 to BT13 may be or may not be the same.

Although the voltage equalizer for a battery pack according to the present invention have been described so far based on the illustrated embodiments, the present invention shall not be limited thereto and the configuration of each part thereof may be replaced with an arbitrary configuration having a similar function.

For example, in each of the embodiments described above, the example was explained in which the NOT gates NOT1 to NOT3 are provided on the subsequent stage sides of the connection points P1 to P3, respectively, as illustrated in Fig. 2, but the NOT gates NOT1 to NOT3 may be omitted, and the logics of "1" and "0" are inverted in determination processing in the equalization diagnostic unit 14, thereby obtaining similar results. Specifically, a diagnostic result may be obtained by inverting "1" or "0" of the signals of "input A" illustrated in the truth tables in Table 1 and Table 2. In this way, in each of the foregoing embodiments, substantially the same processing is able to be executed by inverting bit signals of "1" or "0" and inverting logical operations accordingly.

Further, in the first and second embodiments, the example was explained where equalization is performed for the battery pack which is used as a secondary battery for an electric vehicle, but the present invention is able to be applied to a battery pack installed other than in vehicles.

### Industrial Applicability

The present invention is extremely useful in promptly detecting nonconformity when there is nonconformity in a circuit which equalizes an output voltage of each unit cell provided in a battery pack.

## Claims

1. A voltage equalizer which is provided in a battery pack (23) that includes a series circuit in which more than one battery block (BT1, BT2, BT3) made of more than one unit cell is connected in series, the battery pack configured to generate a desired voltage at both ends of the series circuit, configured to equalize output voltages of the battery blocks, the voltage equalizer comprising:
a discharge resistor (R1, R2, R3) provided at at least one of a positive electrode and a negative electrode of each of the battery blocks;
an equalization switch (SW1, SW2, SW3) provided between the positive electrode and the negative electrode of each of the battery blocks (BT1, BT2, BT3), the equalization switch configured to switch connection and disconnection between the positive electrode and the negative electrode of each of the battery blocks through the discharge resistor;
an equalization controlling unit (15) configured to generate an equalization control signal made of a bit string of a first status signal or a second status signal that determines connection or disconnection of the equalization switch (SW1, SW2, SW3) when an equalization start command is given, and output the equalization control signal to the corresponding equalization switch so as to control connection and disconnection of the equalization switch;
an equalization diagnostic unit (14) configured to obtain an equalization detection signal of each of the battery blocks (BT1, BT2, BT3), the equalization detection signal being made of a bit string of the first status signal or the second status signal based on a voltage generated at a connection point (P1, P2, P3) of the equalization switch (SW1, SW2, SW3) and the discharge resistor (R1, R2, R3) corresponding to each of the battery blocks, also obtain the equalization control signal, and diagnose an operation status of the equalization switch based on the equalization detection signal and the equalization control signal, the equalization diagnostic unit (14) configured to compare the equalization detection signal corresponding to the equalization switch to the equalization control signal thereby determining whether or not equalization processing is executed in conformity for each of the battery blocks based on a result of the comparison; and
a latch circuit configured to output one of the first status signal and the second status signal when the equalization start command is given, and output the other one of the first status signal and the second status signal when an equalization end command is given, wherein
the equalization diagnostic unit (14) is configured to obtain a latch signal that is an output signal from the latch circuit, and is configured to determine whether or not the equalization processing for each of the battery blocks (BT1, BT2, BT3) is executed in conformity in view of the latch signal, in addition to the comparison between the equalization detection signal corresponding to the equalization switch and the equalization control signal.

2. The voltage equalizer according to claim 1, wherein with regard to corresponding battery block (BT1, BT2, BT3), the equalization controlling unit (15) is configured to output the equalization control signal which is the first status signal when equalization is to be executed, and is the second status signal when equalization is not executed,
the equalization detection signal is the first status signal when the equalization switch corresponding to the battery block is connected, and is the second status signal when the equalization switch is disconnected, and
the equalization diagnostic unit (14) is configured to determine for the equalization switch corresponding to the battery block that the operation of the equalization switch is conformity when the equalization detection signal and the equalization control signal coincide with each other, and that the operation of the equalization switch is nonconformity when the equalization detection signal and the equalization control signal do not coincide with each other.

3. The voltage equalizer according to claim 2, wherein
the latch signal becomes the first status signal when the equalization start command is given, and becomes the second status signal when the equalization end command is given, and,
with regard to the corresponding battery block (BT1, BT2, BT3), the equalization diagnostic unit (14) is configured to
determine that the operation of the equalization switch is conformity when the latch signal is the first status signal and both of the equalization detection signal and the equalization control signal are the first status signals, and
determine that the operation of the equalization switch is nonconformity when the latch signal is the second status signal, and at least one of the equalization detection signal and the equalization control signal is the first status signal.

## Patentansprüche

1. Spannungsausgleicher, der bereitgestellt ist in einem Batteriestapel (23), der eine Reihenschaltung enthält, in der mehr als ein Batterieblock (BT1, BT2, BT3), bestehend aus mehr als einer Einheitszelle, in Reihe verbunden ist, wobei der Batteriestapel konfiguriert ist zum Erzeugen einer gewünschten Spannung an beiden Enden der Reihenschaltung, konfiguriert zum Ausgleichen von Ausgangsspannungen der Batterieblöcke, wobei der Spannungsausgleicher umfasst:
einen Entladewiderstand (R1, R2, R3), bereitgestellt an zumindest einer von einer positiven Elektrode und einer negativen Elektrode von jedem der Batterieblöcke;
einen Ausgleichsschalter (SW1, SW2, SW3), bereitgestellt zwischen der positiven Elektrode und der negativen Elektrode von jedem der Batterieblöcke (BT1, BT2, BT3), wobei der Ausgleichsschalter konfiguriert ist zum Schalten einer Verbindung und Trennung zwischen der positiven Elektrode und der negativen Elektrode von jedem der Batterieblöcke über den Entladewiderstand;
eine Ausgleichssteuereinheit (15), konfiguriert zum Erzeugen eines Ausgleichssteuersignals, das aus einem Bit-String von einem ersten Statussignal oder einem zweiten Statussignal besteht, das eine Verbindung oder Trennung des Ausgleichsschalters (SW1, SW2, SW3) bestimmt, wenn eine Ausgleichsstartanweisung gegeben ist, und zum Ausgeben des Ausgleichssteuersignals an den entsprechenden Ausgleichsschalter, um Trennen und Verbinden des Ausgleichsschalters zu steuern;
eine Ausgleichsdiagnoseeinheit (14), konfiguriert zum Erhalten eines Ausgleichsdetektionssignals von jedem der Batterieblöcke (BT1, BT2, BT3), wobei das Ausgleichsdetektionssignal aus einem Bit-String des ersten Statussignals oder des zweiten Statussignals besteht, basierend auf einer Spannung, die erzeugt wird an einem Verbindungspunkt (P1, P2, P3) des Ausgleichsschalters (SW1, SW2, SW3) und des Entladewiderstands (R1, R2, R3) entsprechend jedem der Batterieblöcke, und ferner zum Erhalten des Ausgleichssteuersignals, und zum Bestimmen eines Betriebsstatus des Ausgleichsschalters auf Grundlage des Ausgleichsdetektionssignals und des Ausgleichssteuersignals, wobei die Ausgleichsdiagnoseeinheit (14) konfiguriert ist zum Vergleichen des Ausgleichsdetektionssignals entsprechend dem Ausgleichsschalter mit dem Ausgleichssteuersignal, um dadurch zu bestimmen, ob oder ob nicht eine Ausgleichsverarbeitung in Übereinstimmung für jeden der Batterieblöcke auf Grundlage eines Resultats des Vergleichs ausgeführt wird; und
eine Latch-Schaltung, konfiguriert zum Ausgeben von einem von dem ersten Statussignal und dem zweiten Statussignal, wenn die Ausgleichsstartanweisung gegeben ist, und zum Ausgeben des anderen von dem ersten Statussignal und dem zweiten Statussignal, wenn eine Ausgleichsbeendigungsanweisung gegeben ist, wobei
die Ausgleichsdiagnoseeinheit (14) konfiguriert ist zum Erhalten eines Latch-Signals, wobei es sich um ein Ausgangssignal von der Latch-Schaltung handelt, und konfiguriert zum Bestimmen, ob oder ob nicht die Ausgleichsverarbeitung für jeden der Batterieblöcke (BT1, BT2, BT3) in Übereinstimmung im Hinblick auf das Latch-Signal ausgeführt wird, zusätzlich zu dem Vergleich zwischen dem Ausgleichsdetektionssignal entsprechend dem Ausgleichsschalter und dem Ausgleichssteuersignal.

2. Spannungsausgleicher nach Anspruch 1, wobei
mit Bezug auf einen entsprechenden Batterieblock (BT1, BT2, BT3) die Ausgleichssteuereinheit (15) konfiguriert ist zum Ausgeben des Ausgleichssteuersignals, wobei es sich um das erste Statussignal handelt, wenn ein Ausgleich auszuführen ist, und wobei es sich um das zweite Statussignal handelt, wenn ein Ausgleich nicht ausgeführt wird,
wobei das Ausgleichsdetektionssignal das erste Statussignal ist, wenn der Ausgleichsschalter entsprechend dem Batterieblock verbunden ist, und das zweite Statussignal ist, wenn der Ausgleichsschalter getrennt ist, und
die Ausgleichsdiagnoseeinheit (14) konfiguriert ist zum Bestimmen für den Ausgleichsschalter entsprechend dem Batterieblock, dass der Betrieb des Ausgleichsschalters in Übereinstimmung ist, wenn das Ausgleichsdetektionssignal und das Ausgleichssteuersignal miteinander übereinstimmen, und dass der Betrieb des Ausgleichsschalters nicht in Übereinstimmung ist, wenn das Ausgleichsdetektionssignal und das Ausgleichssteuersignal nicht miteinander übereinstimmen.

3. Spannungsausgleicher nach Anspruch 2, wobei
das Latch-Signal zu dem ersten Statussignal wird, wenn die Ausgleichsstartanweisung gegeben ist, und zu dem zweiten Statussignal wird, wenn die Ausgleichsbeendigungsanweisung gegeben ist, und wobei, bezüglich dem entsprechenden Batterieblock (BT1, BT2, BT3), die Ausgleichsdiagnoseeinheit (14) konfiguriert ist zum
Bestimmen, dass der Betrieb des Ausgleichsschalters in Übereinstimmung ist, wenn das Latch-Signal das erste Statussignal ist und sowohl das Ausgleichsdetektionssignal als auch das Ausgleichssteuersignal das erste Statussignal sind, und
Bestimmen, dass der Betrieb des Ausgleichsschalters nicht in Übereinstimmung ist, wenn das Latch-Signal das zweite Statussignal ist, und zumindest eines von dem Ausgleichsdetektionssignal und dem Ausgleichssteuersignal das erste Statussignal ist.

## Revendications

1. Egaliseur de tension qui est aménagé dans un jeu de batteries (23) qui comprend un circuit en série dans lequel plusieurs blocs-batterie (BT1, BT2, BT3) constitués de plusieurs éléments unitaires sont connectés en série, le jeu de batteries étant conçu pour produire une tension souhaitée aux deux extrémités du circuit en série, conçu pour égaliser les tensions de sortie des blocs-batterie, l'égaliseur de tension comprenant :
une résistance de décharge (R1, R2, R3) prévue sur au moins l'une ou l'autre d'une électrode positive ou d'une électrode négative de chacun des blocs-batterie ; un commutateur d'égalisation (SW1, SW2, SW3) prévu entre l'électrode positive et l'électrode négative de chacun des blocs-batterie (BT1, BT2, BT3), le commutateur d'égalisation étant conçu pour basculer entre la connexion et la déconnexion de l'électrode positive et de l'électrode négative de chacun des blocs-batterie par le biais de la résistance de décharge ;
une unité de commande d'égalisation (15) conçue pour produire un signal de commande d'égalisation constitué d'un train de bits d'un premier signal d'état ou d'un second signal d'état qui détermine la connexion ou la déconnexion du commutateur d'égalisation (SW1, SW2, SW3) lorsqu'un ordre de début d'égalisation est donné et délivrer le signal de commande d'égalisation au commutateur d'égalisation correspondant de manière à commander la connexion et la déconnexion du commutateur d'égalisation ;
une unité de diagnostic d'égalisation (14) conçue pour obtenir un signal de détection d'égalisation de chacun des blocs-batterie (BT1, BT2, BT3), le signal de détection d'égalisation étant constitué d'un train de bits du premier signal d'état ou du second signal d'état sur la base d'une tension produite au point de connexion (P1, P2, P3) du commutateur d'égalisation (SW1, SW2, SW3) et de la résistance de décharge (R1, R2, R3) correspondant à chacun des blocs-batterie, ainsi que pour obtenir le signal de commande d'égalisation, et diagnostiquer l'état de fonctionnement du commutateur d'égalisation sur la base du signal de détection d'égalisation et du signal de commande d'égalisation, l'unité de diagnostic d'égalisation (14) étant conçue pour comparer le signal de détection d'égalisation correspondant au commutateur d'égalisation au signal de commande d'égalisation afin de déterminer si le traitement d'égalisation est exécuté ou non de manière conforme pour chacun des blocs-batterie en fonction du résultat de la comparaison ; et
un circuit de verrouillage conçu pour délivrer l'un du premier signal d'état et du second signal d'état lorsque l'ordre de début d'égalisation est donné et délivrer l'autre du premier signal d'état et du second signal d'état lorsqu'un ordre de fin d'égalisation est donné, dans lequel :
l'unité de diagnostic d'égalisation (14) est conçue pour obtenir un signal de verrouillage qui est un signal de sortie du circuit de verrouillage et est conçue pour déterminer si le traitement d'égalisation de chacun des blocs-batterie (BT1, BT2, BT3) est exécuté ou non de manière conforme en fonction du signal de verrouillage, en plus de la comparaison entre le signal de détection d'égalisation correspondant au commutateur d'égalisation et le signal de commande d'égalisation.

2. Egaliseur de tension selon la revendication 1, dans lequel :
en ce qui concerne le bloc-batterie correspondant (BT1, BT2, BT3), l'unité de commande d'égalisation (15) est conçue pour émettre le signal de commande d'égalisation qui est le premier signal d'état lorsque l'égalisation doit être exécutée et qui est le second signal d'état lorsque l'égalisation n'est pas exécutée,
le signal de détection d'égalisation est le premier signal d'état lorsque le commutateur d'égalisation correspondant au bloc-batterie est connecté et est le second signal d'état lorsque le commutateur d'égalisation est déconnecté, et
l'unité de diagnostic d'égalisation (14) est conçue pour déterminer pour le commutateur d'égalisation correspondant au bloc-batterie que le fonctionnement du commutateur d'égalisation est conforme lorsque le signal de détection d'égalisation et le signal de commande d'égalisation coïncident, et que le fonctionnement du commutateur d'égalisation n'est pas conforme lorsque le signal de détection d'égalisation et le signal de commande d'égalisation ne coïncident pas.

3. Egaliseur de tension selon la revendication 2, dans lequel :
le signal de verrouillage est le premier signal d'état lorsque l'ordre de début d'égalisation est donné et est le second signal d'état lorsque l'ordre de fin d'égalisation est donné et,
en ce qui concerne le bloc-batterie correspondant (BT1, BT2, BT3), l'unité de diagnostic d'égalisation (14) est conçue pour
déterminer que le fonctionnement du commutateur d'égalisation est conforme lorsque le signal de verrouillage est le premier signal d'état et que le signal de détection d'égalisation et le signal de commande d'égalisation sont tous deux les premiers signaux d'état, et pour
déterminer que le fonctionnement du commutateur d'égalisation n'est pas conforme lorsque le signal de verrouillage est le second signal d'état et qu'au moins l'un du signal de détection d'égalisation et du signal de commande d'égalisation est le premier signal d'état.
